# EUROPEAN PATENT APPLICATION

(11) **EP 4 822 376 A1**
(43) Date of publication of application: **14.10.2026**
(21) Application number: 26164831.5
(22) Date of filing: 13.03.2026
(51) Int. Cl.: G01R 31/52, H02H 1/00

(54) **METHOD AND SYSTEM FOR HIGH-IMPEDANCE FAULT (HIF) DETECTION IN A NETWORK**

(30) Priority: 09.04.2025 IN 202521034907
(71) Applicant: Tata Consultancy Services Limited, 400021 Mumbai, Maharashtra (IN)
(72) Inventor: RAVI KUMAR, Bandi, 411057 Pune, Maharashtra (IN); RAJAGOPAL, Narayanan, 560066 Bangalore, Karnataka (IN)
(74) Representative: Goddar, Heinz J.

(57) **Abstract**

Existing approaches used for HIF detection utilize non-algebraic operations which add to computational complexity, consume more time, use complex algorithms and require a very high-sampling frequency (10-20 kHz). Embodiments disclosed herein provide a method and system for high-impedance fault (HIF) detection in a network. In this method, by shifting a domain digital data one cycle time at a time, and processing associated data, a plurality of Harmonics-based Algebraic Indexes (HAI) that include a half-cycle time domain digital data of a one-cycle time domain digital data, and a magnitude strength of a plurality of non-harmonic frequencies of each of the plurality of digital current signals is determined, which captures information on associated magnitude strength information. Further, a time domain aggregated harmonics-based algebraic index (AHAI) indicating presence or absence of High-Impedance Fault (HIF) in a network being monitored is generated, and accordingly the presence of absence of HIF is detected.

## Description

### CROSS-REFERENCE TO RELATED APPLICATIONS AND PRIORITY

The present application claims priority from Indian application no. 202521034907, filed on April 9, 2025.

### TECHNICAL FIELD

The disclosure herein generally relates to fault detection, and, more particularly, to a method and system for high-impedance fault (HIF) detection in a network.

### BACKGROUND

In an electrical network, a High-Impedance Fault (HIF) occurs when a primary conductor makes unwanted electrical contact with a road surface, sidewalk, sod, tree limb, or with some other surface, or object which restricts flow of current to a level below that reliably detectable by conventional overcurrent devices. A HIF does not have to involve a path to ground and, in fact, whether a ground is involved does not matter to a HIF detector. A HIF can exist between two phase conductors. The HIFs on distribution systems create unique challenges for protection engineers. HIFs that occur do not produce enough fault current to be detectable by conventional overcurrent relays or fuses. The high-impedance of the fault does not result in a substantial increase in current. Thus, they cannot be reliably detected using conventional methods. This is often the case with downed conductors on distribution systems. These downed conductors are a major concern for electric utilities as a public safety hazard. The HIFs if not detected and isolated, could have live downed conductors that can be fatal to public, animals and crewmen. HIFs produce little or no-fault current. Typical fault currents range from 1 to 100 amps with a very erratic waveform.

Various systems/approaches exist, that are used for such HIF detection purposes. The existing approaches have the following disadvantages. Most of the electrical solutions utilize non-algebraic operations such as exponential which is used in discrete Fourier transform (DFT), and logarithms, etc., to detect the HIFs, adding to computational complexity. The existing approaches need more time, for example, more than 2 cycles, to detect HIF. The existing approaches have complex algorithms due to several stages included such as filter, DFT/FFT calculations, sequence components calculations, etc. Also, most of the existing electrical solutions need a very high-sampling frequency (10-20 kHz).

### SUMMARY

Embodiments of the present disclosure present technological improvements as solutions to one or more of the above-mentioned technical problems recognized by the inventors in conventional systems. For example, in one embodiment, A processor implemented method is provided. The method includes: receiving, via one or more hardware processors, a plurality of analogue electric current signals from a plurality of Current Transformers (CT); converting, via an Analogue to Digital converter (ADC) of a High-Impedance Fault Detection (HIFD) relay device executed via the one or more hardware processors, the plurality of analogue electric current signals to a plurality of digital current signals with a predefined sampling frequency; extracting, via the HIFD relay device, one-cycle time domain digital data of a time domain digital data, for each of the plurality of digital current signals; generating, via the HIFD relay device, a plurality of Harmonics-based Algebraic Indexes (HAI), by iteratively performing, after shifting a one-cycle data window by one sample for each one-cycle time domain digital data of the plurality of digital current signals: extracting a magnitude strength of a plurality of harmonic frequencies and a fundamental frequency of each of the plurality of digital current signals, comprising: obtaining a half-cycle time domain digital data of the one-cycle time domain digital data, wherein the half-cycle digital data comprises half of a plurality of digital current samples of each of the plurality of digital current signals; and calculating a sum of absolute magnitudes (S₁) of the plurality of digital current samples (N/2) for the half-cycle digital data, where in S₁ captures the magnitude strength of the plurality of harmonic frequencies and the fundamental frequency of the plurality of digital current signals; and extracting a magnitude strength of a plurality of non-harmonic frequencies of each of the plurality of digital current signals, by calculating an absolute value of sum of magnitudes (S₂) of the plurality of digital current samples for the one-cycle time domain digital data, wherein S₂ captures the magnitude strength of the plurality of non-harmonic frequencies of each of the plurality of digital current signals; determining a value of the plurality of HAI, based on the S₂ and S₁, as: $HAI = \frac{{S}_{2} / {S}_{1}}{{S}_{1} + {S}_{2}}$, wherein value of the HAI for the plurality of digital current signals forms the plurality of HAI; and generating, via the HIFD relay device, a time domain aggregated harmonics-based algebraic index (AHAI) as equal to sum of the plurality of HAI, wherein the AHAI indicates a presence or an absence of High-Impedance Fault (HIF) in a network being monitored.

In an aspect of the method, a value of the AHAI exceeding a predefined threshold continuously for more than a pre-defined number of cycles of duration indicates the presence of the HIF in the network, and wherein if the presence of HIF is detected, the HIFD relay device sends a trip signal to a circuit breaker.

In another aspect of the method, a value of the AHAI a) below a predefined threshold, or b) exceeding the predefined threshold, continuously for not more than a pre-defined number of cycles of duration indicates the absence of the HIF, and wherein if the absence of the HIF is confirmed, the AHAI is recalculated by shifting the one-cycle data window by one sample.

In another aspect, a system is provided. The system includes one or more hardware processors, a communication interface, and a memory storing a plurality of instructions. The plurality of instructions cause the one or more hardware processors to: receive a plurality of analogue electric current signals from a plurality of Current Transformers (CT); convert, via an Analogue to Digital Converter (ADC) of a High-Impedance Fault Detection (HIFD) relay device executed via the one or more hardware processors, the plurality of analogue electric current signals to a plurality of digital current signals with a predefined sampling frequency; extract, via the HIFD relay device, one-cycle time domain digital data of a time domain digital data, for each of the plurality of digital current signals; generate, via the HIFD relay device, a plurality of Harmonics-based Algebraic Indexes (HAI), by iteratively performing, after shifting a one-cycle data window by one sample for each one-cycle time domain digital data of the plurality of digital current signals: extracting a magnitude strength of a plurality of harmonic frequencies and a fundamental frequency of each of the plurality of digital current signals, comprising: obtaining a half-cycle time domain digital data of the one-cycle time domain digital data, wherein the half-cycle digital data comprises half of a plurality of digital current samples of each of the plurality of digital current signals; and calculating a sum of absolute magnitudes (S₁) of the plurality of digital current samples (N/2) for the half-cycle digital data, where in S₁ captures the magnitude strength of the plurality of harmonic frequencies and the fundamental frequency of the digital current signal; and extracting a magnitude strength of a plurality of non-harmonic frequencies of each of the plurality of digital current signals, by calculating an absolute value of sum of magnitudes (S₂) of the plurality of digital current samples for the one-cycle time domain digital data, wherein S₂ captures the magnitude strength of the plurality of non-harmonic frequencies of the digital current signal; determining value of a harmonics-based algebraic index (HAI), based on the S₂ and S₁, as: $HAI = \frac{{S}_{2} / {S}_{1}}{{S}_{1} + {S}_{2}}$ , wherein value of the HAI for the plurality of digital current signals forms the plurality of HAI; and generate, via the HIFD relay device, a time domain aggregated harmonics-based algebraic index (AHAI) as equal to sum of the plurality of HAI, wherein the AHAI indicates presence or absence of High-Impedance Fault (HIF) in a network being monitored.

In an aspect of the system, value of the AHAI exceeding a predefined threshold continuously for more than a pre-defined number of cycles of duration indicates the presence of the HIF in the network, and wherein if the presence of HIF is detected, the HIFD relay device sends a trip signal to a circuit breaker.

In another aspect of the system, wherein value of the AHAI a) below a predefined threshold, or b) exceeding the predefined threshold continuously, for not more than a pre-defined number of cycles of duration indicates the absence of the HIF, and wherein if the absence of the HIF is confirmed, the AHAI is recalculated by shifting the one-cycle data window by one sample.

In yet another aspect, there are provided one or more non-transitory machine-readable information storage mediums comprising one or more instructions which when executed by one or more hardware processors cause: receiving a plurality of analogue electric current signals from a plurality of Current Transformers (CT); converting, via an Analogue to Digital converter (ADC) of a High-Impedance Fault Detection (HIFD) relay device executed via the one or more hardware processors, the plurality of analogue electric current signals to a plurality of digital current signals with a predefined sampling frequency; extracting, via the HIFD relay device, one-cycle time domain digital data of a time domain digital data, for each of the plurality of digital current signals; generating, via the HIFD relay device, a plurality of Harmonics-based Algebraic Indexes (HAI), by iteratively performing, after shifting a one-cycle data window by one sample for each one-cycle time domain digital data of the plurality of digital current signals: extracting a magnitude strength of a plurality of harmonic frequencies and a fundamental frequency of each of the plurality of digital current signals, comprising: obtaining a half-cycle time domain digital data of the one-cycle time domain digital data, wherein the half-cycle digital data comprises half of a plurality of digital current samples of each of the plurality of digital current signals; and calculating a sum of absolute magnitudes (S₁) of the plurality of digital current samples (N/2) for the half-cycle digital data, where in S₁ captures the magnitude strength of the plurality of harmonic frequencies and the fundamental frequency of the plurality of digital current signals; and extracting a magnitude strength of a plurality of non-harmonic frequencies of each of the plurality of digital current signals, by calculating an absolute value of sum of magnitudes (S₂) of the plurality of digital current samples for the one-cycle time domain digital data, wherein S₂ captures the magnitude strength of the plurality of non-harmonic frequencies of the digital current signal; determining value of a harmonics-based algebraic index (HAI), based on the S₂ and S₁, as: $HAI = \frac{{S}_{2} / {S}_{1}}{{S}_{1} + {S}_{2}}$, wherein value of the HAI for the plurality of digital current signals forms the plurality of HAI; and generating, via the HIFD relay device, a time domain aggregated harmonics-based algebraic index (AHAI) as equal to sum of the plurality of HAI, wherein the AHAI indicates presence or absence of High-Impedance Fault (HIF) in a network being monitored.

In an aspect of the non-transitory computer readable medium, value of the AHAI exceeding a predefined threshold continuously for more than a pre-defined number of cycles of duration indicates the presence of the HIF in the network, and wherein if the presence of HIF is detected, the HIFD relay device sends a trip signal to a circuit breaker.

In another aspect of the non-transitory computer readable medium, wherein value of the AHAI a) below a predefined threshold, or b) exceeding the predefined threshold continuously, for not more than a pre-defined number of cycles of duration indicates the absence of the HIF, and wherein if the absence of the HIF is confirmed, the AHAI is recalculated by shifting the one-cycle data window by one sample.

It is to be understood that both the foregoing general description and the following detailed description are exemplary and explanatory only and are not restrictive of the invention, as claimed.

### BRIEF DESCRIPTION OF THE DRAWINGS

The accompanying drawings, which are incorporated in and constitute a part of this disclosure, illustrate exemplary embodiments and, together with the description, serve to explain the disclosed principles:
FIG. 1 illustrates an exemplary system for High-Impedance Fault (HIF) detection in a network, according to some embodiments of the present disclosure.
FIGS. 2A and 2B are flow diagrams depicting steps involved in the process of the HIF detection in the network, using the system of FIG. 1, according to some embodiments of the present disclosure.
FIG. 3 is a flow diagram depicting steps involved in the process of generating a plurality of harmonics-based algebraic indexes (HAI), for the HIF detection in the network, using the system of FIG. 1, according to some embodiments of the present disclosure.
FIG. 4 illustrates an electrical network representation of the system of FIG. 1, for the High-Impedance Fault (HIF) detection, in accordance with some embodiments of the present disclosure.
FIG. 5A through FIG. 5E illustrate experimental results associated with high-impedance fault detection, in accordance with some embodiments of the present disclosure.

### DETAILED DESCRIPTION OF EMBODIMENTS

Exemplary embodiments are described with reference to the accompanying drawings. In the figures, the left-most digit(s) of a reference number identifies the figure in which the reference number first appears. Wherever convenient, the same reference numbers are used throughout the drawings to refer to the same or like parts. While examples and features of disclosed principles are described herein, modifications, adaptations, and other implementations are possible without departing from the scope of the disclosed embodiments.

A High-Impedance Fault (HIF) does not have to involve a path to ground and, in fact, whether a ground is involved does not matter to a HIF detector. The High-Impedance of the fault does not result in a substantial increase in current. Thus, they cannot be reliably detected using conventional methods. The HIFs if not detected and isolated, could have live downed conductors that can be fatal to public, animals and crewmen. HIFs produce little or no-fault current. Typical fault currents range from 1 to 100 amps with a very erratic waveform. Various systems/approaches exist, that are used for such HIF detection purposes. However, existing approaches have the following disadvantages. Most of the electrical solutions utilize non-algebraic operations such as exponential which is used in discrete Fourier transform (DFT), and logarithms, etc., to detect the HIFs, adding to computational complexity. The existing approaches need more time, for example, more than 2 cycles, to detect HIF. The existing approaches have complex algorithms due to several stages included such as filter, DFT/FFT calculations, sequence components calculations, etc. Also, most of the existing electrical solutions need a very high-sampling frequency (10-20 kHz).

To address these challenges, embodiments disclosed herein provide a method and system for HIF detection in a network. In this method, a plurality of analogue electric current signals are received from a plurality of Current Transformers (CT). Further, the plurality of analogue electric current signals are converted, via an analogue to digital converter (ADC) of a High-Impedance Fault Detection (HIFD) relay device, to a plurality of digital current signals with a predefined sampling frequency. Further, one-cycle time domain digital data of a time domain digital data is extracted for each of the plurality of digital current signals. Further, a plurality of harmonics-based algebraic indexes (HAI) are generated, by iteratively performing, after shifting a one-cycle data window by one sample for each one-cycle time domain digital data of the plurality of digital current signals, extraction of a magnitude strength of a plurality of harmonic frequencies and a fundamental frequency of each of the plurality of digital current signals, and a magnitude strength of a plurality of non-harmonic frequencies of each of the plurality of digital current signals. To extract the magnitude strength of the plurality of harmonic frequencies and a fundamental frequency, a half-cycle time domain digital data of the one-cycle time domain digital data is obtained, wherein the half-cycle digital data comprises half of a plurality of digital current samples of each of the plurality of digital current signals. Further, a sum of absolute magnitudes (S₁) of the plurality of digital current samples (N/2) is computed for the half-cycle digital data, where in S₁ captures the magnitude strength of the plurality of harmonic frequencies and the fundamental frequency of the digital current signal. Similarly, the magnitude strength of a plurality of non-harmonic frequencies of each of the plurality of digital current signals is computed by calculating an absolute value of sum of magnitudes (S₂) of the plurality of digital current samples for the one-cycle time domain digital data, wherein S₂ captures the magnitude strength of the plurality of non-harmonic frequencies of the digital current signal. Further, value of a harmonics-based algebraic index (HAI) is determined based on the S₂ and S₁, as: $HAI = \frac{{S}_{2} / {S}_{1}}{{S}_{1} + {S}_{2}}$, wherein value of the HAI for the plurality of digital current signals forms the plurality of HAI. Further, a time domain aggregated harmonics-based algebraic index (AHAI) is generated as equal to sum of the plurality of HAI, wherein the AHAI indicates presence or absence of High-Impedance Fault (HIF) in a network being monitored. This approach addresses the aforementioned challenges of the existing approaches, by means of the following characteristics of the approach. The approach uses only algebraic operations such as addition and division, and also does not require complex filters, DFT/FFT calculations, sequence components calculations, and so on, which reduces computational complexity. As opposed to some of the existing approaches which require high sampling frequency, the proposed approach needs a sampling frequency of around 3 kHz, thereby reducing cost of analogue to digital converter (ADC), in turn making the approach more economical.

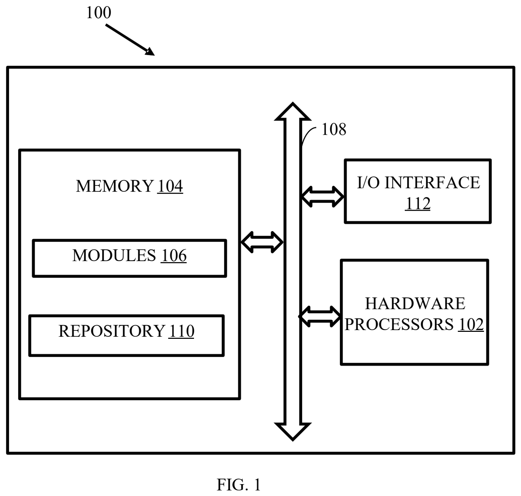

Referring now to the drawings, and more particularly to FIG. 1 through FIG. 5E, where similar reference characters denote corresponding features consistently throughout the figures, there are shown preferred embodiments and these embodiments are described in the context of the following exemplary system and/or method.

FIG. 1 illustrates an exemplary system for High-Impedance Fault (HIF) detection in a network, according to some embodiments of the present disclosure. The system 100 includes or is otherwise in communication with hardware processors 102, at least one memory such as a memory 104, an I/O interface 112. The hardware processors 102, memory 104, and the Input /Output (I/O) interface 112 may be coupled by a system bus such as a system bus 108 or a similar mechanism. In an embodiment, the hardware processors 102 can be one or more hardware processors.

The I/O interface 112 may include a variety of software and hardware interfaces, for example, a web interface, a graphical user interface, and the like. The I/O interface 112 may include a variety of software and hardware interfaces, for example, interfaces for peripheral device(s), such as a keyboard, a mouse, an external memory, a printer and the like. Further, the I/O interface 112 may enable the system 100 to communicate with other devices, such as web servers, and external databases.

The I/O interface 112 can facilitate multiple communications within a wide variety of networks and protocol types, including wired networks, for example, local area network (LAN), cable, etc., and wireless networks, such as Wireless LAN (WLAN), cellular, or satellite. For the purpose, the I/O interface 112 may include one or more ports for connecting several computing systems with one another or to another server computer. The I/O interface 112 may include one or more ports for connecting several devices to one another or to another server.

The one or more hardware processors 102 may be implemented as one or more microprocessors, microcomputers, microcontrollers, digital signal processors, central processing units, node machines, logic circuitries, and/or any devices that manipulate signals based on operational instructions. Among other capabilities, the one or more hardware processors 102 is configured to fetch and execute computer-readable instructions stored in the memory 104.

The memory 104 may include any computer-readable medium known in the art including, for example, volatile memory, such as static random-access memory (SRAM) and dynamic random-access memory (DRAM), and/or non-volatile memory, such as read only memory (ROM), erasable programmable ROM, flash memories, hard disks, optical disks, and magnetic tapes. In an embodiment, the memory 104 includes a plurality of modules 106.

The plurality of modules 106 include programs or coded instructions that supplement applications or functions performed by the system 100 for executing different steps involved in the process of HIF detection, being performed by the system of FIG. 1. The plurality of modules 106, amongst other things, can include routines, programs, objects, components, and data structures, which performs particular tasks or implement particular abstract data types. The plurality of modules 106 may also be used as, signal processor(s), node machine(s), logic circuitries, and/or any other device or component that manipulates signals based on operational instructions. Further, the plurality of modules 106 can be used by hardware, by computer-readable instructions executed by the one or more hardware processors 102, or by a combination thereof. The plurality of modules 106 can include various sub-modules (not shown). The plurality of modules 106 may include computer-readable instructions that supplement applications or functions performed by the system 100 for the HIF detection.

The data repository (or repository) 110 may include a plurality of abstracted piece of code for refinement and data that is processed, received, or generated as a result of the execution of the plurality of modules in the module(s) 106.

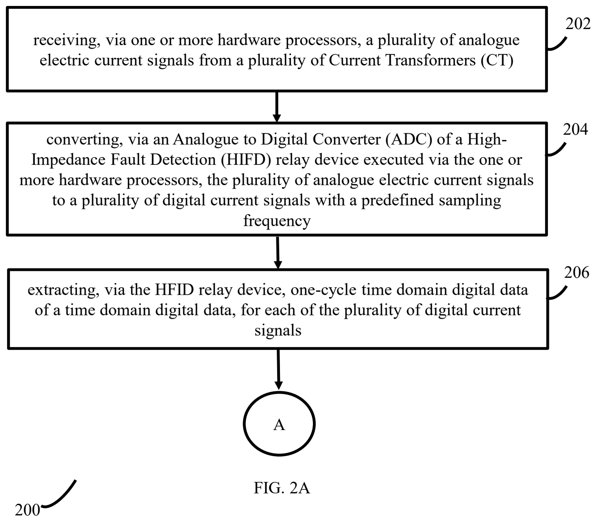

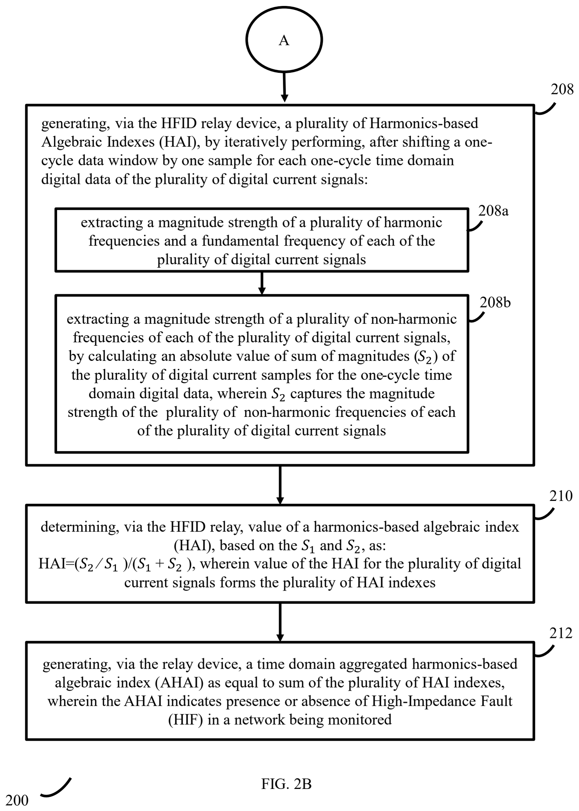

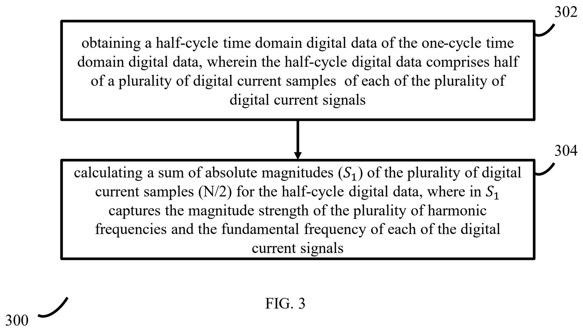

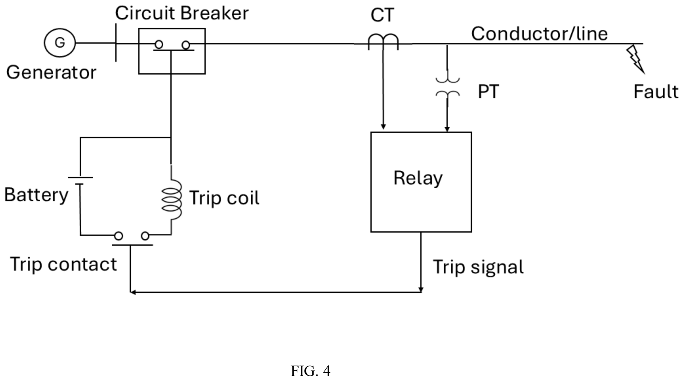

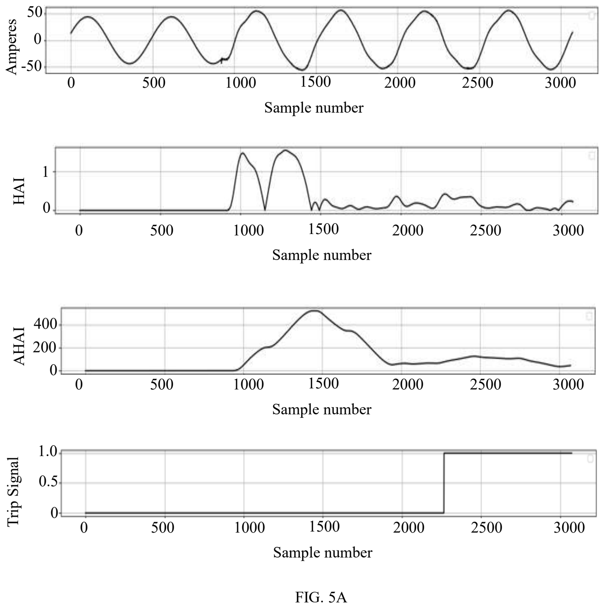

Although the data repository 110 is shown internal to the system 100, it will be noted that, in alternate embodiments, the data repository 110 can also be implemented external to the system 100, where the data repository 110 may be stored within a database (the data repository 110) communicatively coupled to the system 100. The data contained within such an external database may be periodically updated. For example, new data may be added into the database (not shown in FIG. 1) and/or existing data may be modified and/or non-useful data may be deleted from the database. In one example, the data may be stored in an external system, such as a Lightweight Directory Access Protocol (LDAP) directory and a Relational Database Management System (RDBMS). Functions of the components of the system 100 are now explained with reference to the flow diagram in FIGS. 2A and 2B, FIG. 3, the electrical network diagram in FIG. 4 and experimental results associated with high-impedance fault detection in FIG. 5A through FIG. 5E.

FIGS. 2A and 2B are flow diagrams depicting steps involved in the process of the HIF detection in the network, using the system 100 of FIG. 1, according to some embodiments of the present disclosure.

In an embodiment, the system 100 comprises one or more data storage devices or the memory 104 operatively coupled to the processor(s) 102 and is configured to store instructions for execution of steps of the method 200 by the processor(s) or one or more hardware processors 102. The steps of the method 200 of the present disclosure will now be explained with reference to the components or blocks of the system 100 as depicted in FIG. 1 and the steps of flow diagram as depicted in FIGS. 2A and 2B, and the electrical network diagram in FIG. 3. Although process steps, method steps, techniques or the like may be described in a sequential order, such processes, methods, and techniques may be configured to work in alternate orders. In other words, any sequence or order of steps that may be described does not necessarily indicate a requirement that the steps to be performed in that order. The steps of processes described herein may be performed in any order practical. Further, some steps may be performed simultaneously.

Consider the example electrical network diagram in FIG. 4. In the depicted network, for the HIF detection, the steps involved in the method 200 are carried out by the 'relay', i.e., the relay, in this scenario, handles the functions of the system 100. For this reason, the terms 'system 100' and 'relay' or "High-Impedance Fault Detection (HIFD) relay device" or "HIFD relay device" are alternately used.

At step 202 of the method 200, the relay device receives, via one or more hardware processors, a plurality of analogue electric current signals from a plurality of Current Transformers (CT). The analogue electric current signals are received in real-time from the network being monitored. The term "network" in the context of the embodiments disclosed herein refers to an electrical network. Protective CTs are installed at the electric substations in the distribution systems, which stepdown the high-magnitude analogue electric currents on the primary of the CT to the low-magnitude analogue electric currents on secondary of the CT. Here, CT serves two purposes. One is stepdown of analogue electric currents and the other is to provide isolation between the high-power primary side of CT and the low-power secondary side of CT. Stepdown and isolation are necessary because the devices on the secondary side of CT are low-power devices which get damaged if they are directly connected to the high-power primary side of CT.

Further, at step 204 of the method 200, the system 100 converts, via an Analogue to Digital Converter (ADC) of the HIFD relay device executed via the one or more hardware processors 102, the plurality of analogue electric current signals to a plurality of digital current signals with a predefined sampling frequency. The stepped down low-magnitude analogue electric currents on the secondary of the protective CT are fed to a low-power operating device called as a protection relay. The protection relay is not capable of processing the analogue electric current signals which inherently have infinite samples of information in them, hence, for this, the infinite samples are converted to finite samples, by means of sampling using the ADC. This converts the low-magnitude analogue electric currents to low-magnitude digital electric currents.

Further, at step 206 of the method 200, the relay device extracts one-cycle time domain digital data of a time domain digital data, for each of the plurality of digital current signals. The one-cycle time domain digital data corresponds to a specific time period, for example, 20 milli second and 16.667 milli second for 50 Hz and 60 Hz, respectively, as may be pre-defined and configured with the relay device. The one-cycle time domain digital data comprises a plurality of digital current signals (N). Let total numbers of digital current signals in one cycle data be 'N'; 'n' be the sample number; and 'i' be the digital or sampled current signal. Let 'in' be the nth sample of a current signal 'i'.

Further, at step 208 of the method 200, the relay device generates a plurality of Harmonics-based Algebraic Index (HAI). The relay device generates the plurality of HAI, by iteratively performing, after shifting a one-cycle data window by one sample for each one-cycle time domain digital data of the plurality of digital current signals, the steps 208a and 208b. At the step 208a, the relay device extracts a magnitude strength of a plurality of harmonic frequencies and a fundamental frequency of each of the plurality of digital current signals. Various steps involved in the process of extracting the magnitude strength of a plurality of harmonic frequencies and a fundamental frequency of each of the plurality of digital current signals are depicted in method 300 in FIG. 3. At step 302 of the method 300, the relay device obtains a half-cycle time domain digital data of the one-cycle time domain digital data. The half-cycle digital data comprises half of a plurality of digital current samples of each of the plurality of digital current signals. Further, a sum of absolute magnitudes (S₁) of the plurality of digital current samples (N/2) is calculated for the half-cycle digital data, as: ${S}_{1} = {\sum }_{n = 1}^{\frac{N}{2}} \left|{i}_{n}\right| ,$ (1)

At this stage, a buffer associated with the relay device contains one-cycle time domain digital electric current data. In this step, only half-cycle data is utilized to calculate a sum, denoted as S₁. Since the one-cycle data consists of 'N' number of samples, half-cycle data consists of 'N/2' number of samples. Let 'in' be the n^{th} sample of current signal 'i'. Absolute magnitudes or values for all the digital electric current data present in the half-cycle, i.e., for 'in', are generated, where n=1,2,...,N/2. The absolute magnitude/value is calculated as follows. The absolute magnitude/value of any number is the number itself if it is a positive value. The absolute magnitude/value of any number is the number multiplied by -1, if it is a negative value (i.e., it is less than zero). After obtaining the absolute magnitudes/values for all the half-cycle data, sum of all these absolute magnitudes/values is calculated. The calculated sum is termed as S₁. Here, S₁ captures the magnitude strength of the plurality of harmonic frequencies and the fundamental frequency of the digital current signal.

Further, at step 304 of the method 300, the relay device extracts the magnitude strength of a plurality of non-harmonic frequencies of each of the plurality of digital current signals, by calculating an absolute value of sum of magnitudes (S₂) of the plurality of digital current samples for the one-cycle time domain digital data, as: ${S}_{2} = \left|{\sum }_{n = 1}^{N} {i}_{n}\right|$ (2)

S₂ captures the magnitude strength of the plurality of non-harmonic frequencies of the digital current signal. The buffer at this stage contains one-cycle time domain digital electric current data. In this step, full-cycle/one-cycle data is utilized to calculate a sum, i.e., S₂. This one-cycle data consists of 'N' number of samples. Let 'in' be the nth sample of the current signal 'i'. Further, the sum of all the digital electric current data present in one-cycle is calculated. Further, the absolute magnitude/value of the calculated sum is calculated as follows. The absolute magnitude/value of any number is the number itself if it is a positive value that means if it is greater than zero. The absolute magnitude/value of any number is the number multiplied by -1, if it is a negative value that means if it is less than zero. The obtained absolute magnitude/value of the calculated sum is termed as S₂. S₂ captures the magnitude strength of the plurality of non-harmonic frequencies of each of the plurality of digital current signals.

Referring back to the method 200, at step 210, the relay device determines value of a harmonics-based algebraic index (HAI), based on the S₂ and S₁, as: $HAI = \frac{{S}_{2} / {S}_{1}}{{S}_{1} + {S}_{2}} ,$ (3)

Value of the HAI for the plurality of digital current signals forms the plurality of HAI. As depicted in equation (3), HAI is a fraction that means it consists of a numerator and a denominator. Firstly, the division of S₂ and S₁ is calculated and stored as the numerator of HAI. Now, the addition of S₂ and S₁ is calculated and stored as the denominator of HAI. Subsequently, HAI is defined as the calculated numerator divided by the calculated denominator.

After the harmonics-based Algebraic index (HAI) is calculated using the extracted magnitude strengths of one cycle data, the calculation of HAI is repeated by shifting the one cycle data window by one sample until HAIs are obtained for every one cycle data window.

Further, at step 212 of the method 200, the relay device generates a time domain aggregated harmonics-based algebraic index (AHAI) as equal to sum of the plurality of HAI. The AHAI indicates a presence or an absence of High-Impedance Fault (HIF) in a network being monitored. Mathematically, AHAI is calculated as given below. $AHAI = \left|{\sum }_{n = 1}^{N} HAI\right|$ (4)

If the value of the AHAI is above a predefined threshold, then the AHAI is recalculated by shifting the one-cycle data window by one sample. A latest AHAI is calculated using the last 'N' number of HAIs. This procedure is repeated for a pre-defined number of cycles, for example, for 2.5cycles. Value of the AHAI exceeding a predefined threshold continuously for more than a pre-defined number of cycles of duration indicates presence of the HIF in the network. If the presence of HIF is detected, the relay device sends a trip signal to a circuit breaker. If the value of the AHAI is a) below a predefined threshold, or b) exceeding the predefined threshold, continuously for not more than a pre-defined number of cycles of duration indicates absence of the HIF, and wherein if the absence of the HIF is confirmed, the AHAI is recalculated by shifting the one-cycle data window by one sample. In the above given example, the calculation of HAI needs one cycle data and the calculation of AHAI needs one more cycle data. Thus, a total of two cycles data is needed to calculate AHAI. Further, another 2.5 cycles are needed to detect HIF. Thus, a total of 4.5 cycles are needed to detect HIF, which is less than the time taken by state of the art references.

### Experimental Data:

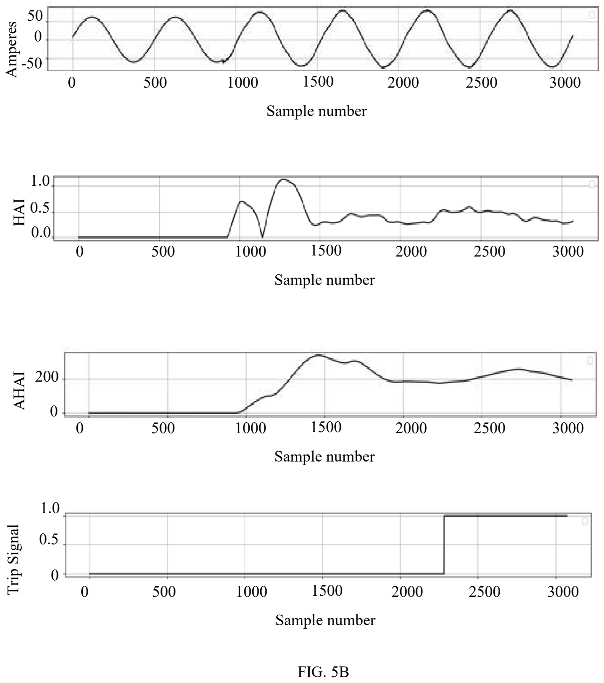

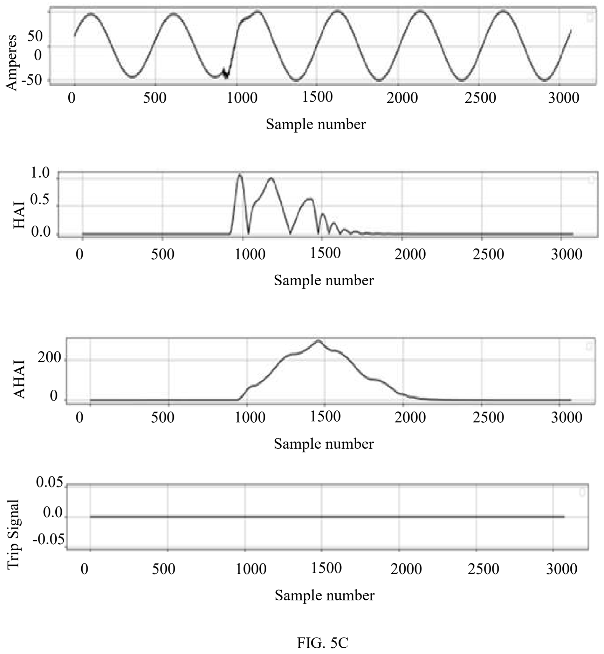

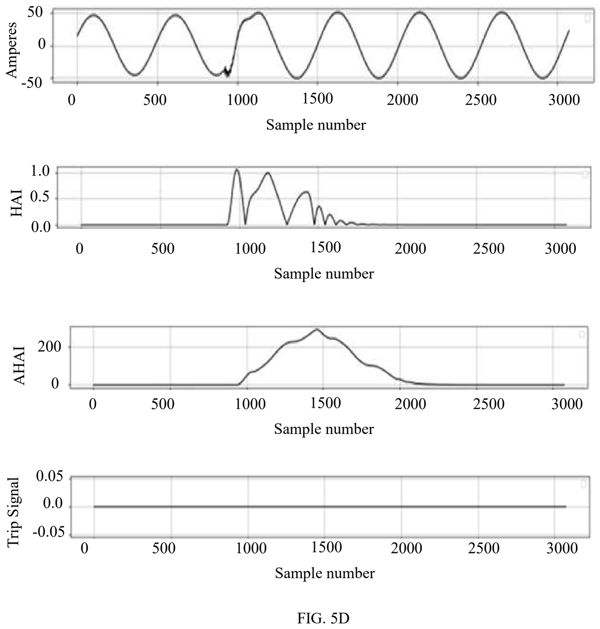

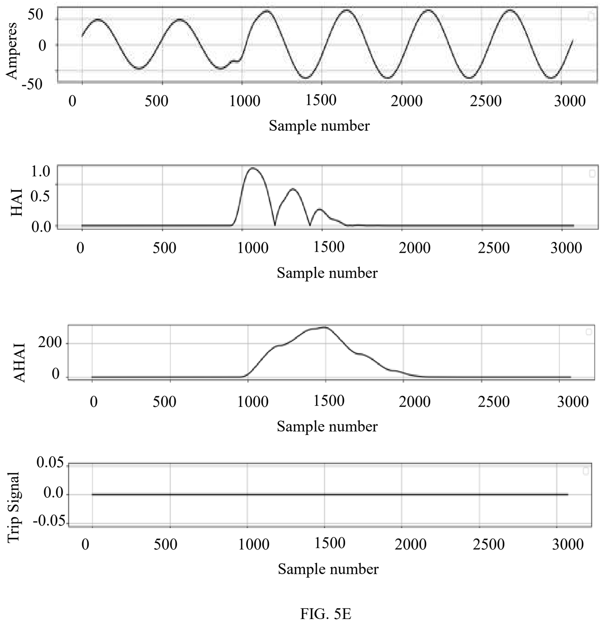

The experimental results are depicted in FIGS. 5A through 5E. In FIG. 5A, the experiments were conducted on a high-impedance fault current signal. The fault inception point is at sample number of 921. HAI, AHAI were calculated and shown in FIG. 5A. Here, N=512 samples and threshold were considered as 30. AHAI value was above the threshold for more than 2.5 cycles, (2.5x512=1280 samples). Thus, trip signal was initiated that means trip signal status is changed from zero to one detecting the HIF. FIG. 5B depicts results of experimentation conducted on a high-impedance fault current signal. The fault inception point is at sample number of 921. HAI, AHAI were calculated and shown in the FIG. 5B. Here, N=512 samples and threshold is considered as 30. AHAI value is above the threshold for more than 2.5 cycles, (2.5x512=1280 samples). Thus, trip signal is initiated that means trip signal status is changed from zero to one detecting the high-impedance fault. FIG. 5C depicts results of experimentation conducted on a steady-state current signal. HAI, AHAI were calculated and shown in FIG. 5C. Here, N=512 samples and threshold was considered as 30. AHAI value was below the threshold always. Thus, trip signal is not initiated that means trip signal status was not changed from zero to one, its status is maintained as zero always. This means that there is no high-impedance fault. FIG. 5D depicts results of experimentation conducted on a load-switching current signal. The HAI, AHAI are calculated as depicted. The load-switching inception point is at sample number of 921. Here, N=512 samples and threshold is considered as 30. AHAI value is not above the threshold for more than 2.5 cycles, (2.5x512=1280 samples). Thus, trip signal is not initiated that means trip signal status is not changed from zero to one, maintaining its status as zero always. This means that there is no high-impedance fault. FIG. 5E depicts results of experimentation conducted on a capacitor-switching current signal. HAI, AHAI are calculated and shown in figure. The capacitor-switching inception point is at sample number of 921. Here, N=512 samples and threshold is considered as 30. AHAI value is not above the threshold for more than 2.5 cycles, (2.5x512=1280 samples). Thus, trip signal is not initiated that means trip signal status is not changed from zero to one, maintaining its status as zero always. This means that there is no high-impedance fault.

The written description describes the subject matter herein to enable any person skilled in the art to make and use the embodiments. The scope of the subject matter embodiments is defined by the claims and may include other modifications that occur to those skilled in the art. Such other modifications are intended to be within the scope of the claims if they have similar elements that do not differ from the literal language of the claims or if they include equivalent elements with insubstantial differences from the literal language of the claims.

The embodiments of present disclosure herein address unresolved problem of High-impedance Fault (HIF) detection in a network. The embodiment, thus provides a mechanism for HIF detection. Moreover, the embodiments herein further provides a mechanism to detect the HIF based on a time domain aggregated harmonics-based algebraic index (AHAI).

It is to be understood that the scope of the protection is extended to such a program and in addition to a computer-readable means having a message therein; such computer-readable storage means contain program-code means for implementation of one or more steps of the method, when the program runs on a server or mobile device or any suitable programmable device. The hardware device can be any kind of device which can be programmed including e.g., any kind of computer like a server or a personal computer, or the like, or any combination thereof. The device may also include means which could be e.g., hardware means like e.g., an application-specific integrated circuit (ASIC), a field-programmable gate array (FPGA), or a combination of hardware and software means, e.g., an ASIC and an FPGA, or at least one microprocessor and at least one memory with software processing components located therein. Thus, the means can include both hardware means and software means. The method embodiments described herein could be implemented in hardware and software. The device may also include software means. Alternatively, the embodiments may be implemented on different hardware devices, e.g., using a plurality of CPUs.

The embodiments herein can comprise hardware and software elements. The embodiments that are implemented in software include but are not limited to, firmware, resident software, microcode, etc. The functions performed by various components described herein may be implemented in other components or combinations of other components. For the purposes of this description, a computer-usable or computer readable medium can be any apparatus that can comprise, store, communicate, propagate, or transport the program for use by or in connection with the instruction execution system, apparatus, or device.

The illustrated steps are set out to explain the exemplary embodiments shown, and it should be anticipated that ongoing technological development will change the manner in which particular functions are performed. These examples are presented herein for purposes of illustration, and not limitation. Further, the boundaries of the functional building blocks have been arbitrarily defined herein for the convenience of the description. Alternative boundaries can be defined so long as the specified functions and relationships thereof are appropriately performed. Alternatives (including equivalents, extensions, variations, deviations, etc., of those described herein) will be apparent to persons skilled in the relevant art(s) based on the teachings contained herein. Such alternatives fall within the scope of the disclosed embodiments. Also, the words "comprising," "having," "containing," and "including," and other similar forms are intended to be equivalent in meaning and be open ended in that an item or items following any one of these words is not meant to be an exhaustive listing of such item or items, or meant to be limited to only the listed item or items. It must also be noted that as used herein and in the appended claims, the singular forms "a," "an," and "the" include plural references unless the context clearly dictates otherwise.

Furthermore, one or more computer-readable storage media may be utilized in implementing embodiments consistent with the present disclosure. A computer-readable storage medium refers to any type of physical memory on which information or data readable by a processor may be stored. Thus, a computer-readable storage medium may store instructions for execution by one or more processors, including instructions for causing the processor(s) to perform steps or stages consistent with the embodiments described herein. The term "computer-readable medium" should be understood to include tangible items and exclude carrier waves and transient signals, i.e., be non-transitory. Examples include random access memory (RAM), read-only memory (ROM), volatile memory, nonvolatile memory, hard drives, CD ROMs, DVDs, flash drives, disks, and any other known physical storage media.

It is intended that the disclosure and examples be considered as exemplary only, with a true scope of disclosed embodiments being indicated by the following claims.

## Claims

1. A processor implemented method (200), comprising:
receiving (202), via one or more hardware processors, a plurality of analogue electric current signals from a plurality of Current Transformers (CT);
converting (204), via an Analogue to Digital Converter (ADC) of a High-Impedance Fault Detection (HIFD) relay device executed via the one or more hardware processors, the plurality of analogue electric current signals to a plurality of digital current signals with a predefined sampling frequency;
extracting (206), via the HIFD relay device, one-cycle time domain digital data of a time domain digital data, for each of the plurality of digital current signals;
generating (208), via the HIFD relay device, a plurality of Harmonics-based Algebraic Indexes (HAI), by iteratively performing, until the plurality of HAI is obtained for every one cycle data window, after shifting a one-cycle data window by one sample for each one-cycle time domain digital data of the plurality of digital current signals:
extracting (208a) a magnitude strength of a plurality of harmonic frequencies and a fundamental frequency of each of the plurality of digital current signals, comprising:
obtaining (302) a half-cycle time domain digital data of the one-cycle time domain digital data, wherein the half-cycle digital data comprises half of a plurality of digital current samples of each of the plurality of digital current signals; and
calculating (304) a sum of absolute magnitudes (S₁) of the plurality of digital current samples (N/2) for the half-cycle digital data, where in S₁ captures the magnitude strength of the plurality of harmonic frequencies and the fundamental frequency of each of the plurality of digital current signals; and
extracting (208b) a magnitude strength of a plurality of non-harmonic frequencies of each of the plurality of digital current signals, by calculating an absolute value of sum of magnitudes (S₂) of the plurality of digital current samples for the one-cycle time domain digital data, wherein S₂ captures the magnitude strength of the plurality of non-harmonic frequencies of each of the plurality of digital current signals;
determining (210), via the HIFD relay device, a value of the plurality of HAI, based on the S₂ and S₁, as_{:} $HAI = \frac{{S}_{2} / {S}_{1}}{{S}_{1} + {S}_{2}} ,$ wherein value of the HAI for the plurality of digital current signals forms the plurality of HAI; and
generating (212), via the HIFD relay device, a time domain aggregated harmonics-based algebraic index (AHAI) as equal to sum of the plurality of HAI, wherein the AHAI indicates a presence or an absence of High-Impedance Fault (HIF) in a network being monitored.

2. The processor implemented method as claimed in claim 1, wherein a value of the AHAI exceeding a predefined threshold continuously for more than a pre-defined number of cycles of duration indicates the presence of the HIF in the network, and wherein if the presence of HIF is detected, the HIFD relay device sends a trip signal to a circuit breaker.

3. The processor implemented method as claimed in claim 1, wherein a value of the AHAI a) below a predefined threshold, or b) exceeding the predefined threshold, continuously for not more than a pre-defined number of cycles of duration indicates the absence of the HIF, and wherein if the absence of the HIF is confirmed, the AHAI is recalculated by shifting the one-cycle data window by one sample.

4. A system (100), comprising:
one or more hardware processors (102);
a communication interface (112); and
a memory (104) storing a plurality of instructions, wherein the plurality of instructions cause the one or more hardware processors (102) to:
receive a plurality of analogue electric current signals from a plurality of Current Transformers (CT);
convert, via an analogue to digital converter (ADC) of a High-Impedance Fault Detection (HIFD) relay device executed via the one or more hardware processors, the plurality of analogue electric current signals to a plurality of digital current signals with a predefined sampling frequency;
extract, via the relay device, one-cycle time domain digital data of a time domain digital data, for each of the plurality of digital current signals;
generate, via the relay device, a plurality of HAI indexes, by iteratively performing, after shifting a one-cycle data window by one sample for each one-cycle time domain digital data of the plurality of digital current signals:
extracting a magnitude strength of a plurality of harmonic frequencies and a fundamental frequency of each of the plurality of digital current signals, comprising:
obtaining a half-cycle time domain digital data of the one-cycle time domain digital data, wherein the half-cycle digital data comprises half of a plurality of digital current samples of each of the plurality of digital current signals; and
calculating a sum of absolute magnitudes (S₁) of the plurality of digital current samples (N/2) for the half-cycle digital data, where in S₁ captures the magnitude strength of the plurality of harmonic frequencies and the fundamental frequency of each of the plurality of digital current signals; and
extracting a magnitude strength of a plurality of non-harmonic frequencies of each of the plurality of digital current signals, by calculating an absolute value of sum of magnitudes (S₂) of the plurality of digital current samples for the one-cycle time domain digital data, wherein S₂ captures the magnitude strength of the plurality of non-harmonic frequencies of each of the plurality of digital current signals; and
extracting a magnitude strength of a plurality of non-harmonic frequencies of each of the plurality of digital current signals, by calculating an absolute value of sum of magnitudes (S₂) of the plurality of digital current samples for the one-cycle time domain digital data, wherein S₂ captures the magnitude strength of the plurality of non-harmonic frequencies of the digital current signal;
determining value of a harmonics-based algebraic index (HAI), based on the S₂ and S₁, as_{:} $HAI = \frac{{S}_{2} / {S}_{1}}{{S}_{1} + {S}_{2}} ,$ wherein value of the HAI for the plurality of digital current signals forms the plurality of HAI indexes; and
generate, via the relay device, a time domain aggregated harmonics-based algebraic index (AHAI) as equal to sum of the plurality of HAI indexes, wherein the AHAI indicates presence or absence of High-Impedance Fault (HIF) in a network being monitored.

5. The system as claimed in claim 4, wherein value of the AHAI exceeding a predefined threshold continuously for more than a pre-defined number of cycles of duration indicates presence of a High-Impedance Fault (HIF) in the network, and wherein if the presence of HIF is detected, the relay device sends a trip signal to a circuit breaker.

6. The system as claimed in claim 4, wherein value of the AHAI a) below a predefined threshold, or b) exceeding the predefined threshold continuously, for not more than a pre-defined number of cycles of duration indicates absence of the HIF, and wherein if the absence of the HIF is confirmed, the AHAI is recalculated by shifting the one-cycle data window by one sample.

7. One or more non-transitory machine-readable information storage mediums comprising one or more instructions which when executed by one or more hardware processors cause:
receiving a plurality of analogue electric current signals from a plurality of Current Transformers (CT);
converting, via an Analogue to Digital Converter (ADC) of a High-Impedance Fault Detection (HIFD) relay device executed via the one or more hardware processors, the plurality of analogue electric current signals to a plurality of digital current signals with a predefined sampling frequency;
extracting, via the HIFD relay device, one-cycle time domain digital data of a time domain digital data, for each of the plurality of digital current signals;
generating, via the HIFD relay device, a plurality of Harmonics-based Algebraic Indexes (HAI), by iteratively performing, until the plurality of HAI is obtained for every one cycle data window, after shifting a one-cycle data window by one sample for each one-cycle time domain digital data of the plurality of digital current signals:
extracting a magnitude strength of a plurality of harmonic frequencies and a fundamental frequency of each of the plurality of digital current signals, comprising:
obtaining a half-cycle time domain digital data of the one-cycle time domain digital data, wherein the half-cycle digital data comprises half of a plurality of digital current samples of each of the plurality of digital current signals; and
calculating a sum of absolute magnitudes (S₁) of the plurality of digital current samples (N/2) for the half-cycle digital data, where in S₁ captures the magnitude strength of the plurality of harmonic frequencies and the fundamental frequency of each of the plurality of digital current signals; and
extracting a magnitude strength of a plurality of non-harmonic frequencies of each of the plurality of digital current signals, by calculating an absolute value of sum of magnitudes (S₂) of the plurality of digital current samples for the one-cycle time domain digital data, wherein S₂ captures the magnitude strength of the plurality of non-harmonic frequencies of each of the plurality of digital current signals;
determining, via the HIFD relay device, a value of the plurality of HAI, based on the S₂ and S₁, as_{:} $HAI = \frac{{S}_{2} / {S}_{1}}{{S}_{1} + {S}_{2}} ,$ wherein value of the HAI for the plurality of digital current signals forms the plurality of HAI; and
generating, via the HIFD relay device, a time domain aggregated harmonics-based algebraic index (AHAI) as equal to sum of the plurality of HAI, wherein the AHAI indicates a presence or an absence of High-Impedance Fault (HIF) in a network being monitored.

8. The one or more non-transitory machine readable information storage mediums as claimed in claim 7, wherein a value of the AHAI exceeding a predefined threshold continuously for more than a pre-defined number of cycles of duration indicates the presence of the HIF in the network, and wherein if the presence of HIF is detected, the HIFD relay device sends a trip signal to a circuit breaker.

9. The one or more non-transitory machine readable information storage mediums as claimed in claim 7, wherein a value of the AHAI a) below a predefined threshold, or b) exceeding the predefined threshold, continuously for not more than a pre-defined number of cycles of duration indicates the absence of the HIF, and wherein if the absence of the HIF is confirmed, the AHAI is recalculated by shifting the one-cycle data window by one sample.
